# EUROPÄISCHE PATENTANMELDUNG

(11) **EP 4 156 875 A1**
(43) Veröffentlichungstag der Anmeldung: **29.03.2023**
(21) Anmeldenummer: 21198605.4
(22) Anmeldetag: 23.09.2021
(51) Int. Cl.: H05K 3/12, H05K 7/14

(54) **VERFAHREN ZUR HERSTELLUNG EINER ELEKTRISCHEN UND/ODER KOMMUNIKATIVEN VERBINDUNG**

(71) Anmelder: Siemens Aktiengesellschaft, 80333 München (DE)
(72) Erfinder: Jähnicke, Jens, 09112 Chemnitz (DE)
(74) Vertreter: Siemens Patent Attorneys

(57) **Zusammenfassung**

Die Erfindung betrifft ein Verfahren zur Herstellung einer elektrischen und/oder kommunikativen Verbindung (V1, V2, V3, V4, V5, V6) zwischen wenigstens zwei in einem Schaltschrank (20) angeordneten Komponenten (24, 25, 27, 28, 29, 30, 31) zur Übertragung elektrischer Energie bzw. zum Transport von Daten, wobei die elektrische und/oder kommunikative Verbindung (24, 25, 27, 28, 29, 30, 31) durch Aufbringen eines Materials (2) auf eine Rückwand (10) des Schaltschranks (20) geschaffen wird.

## Beschreibung

In industriellen Anlagen und Maschinen werden elektrische Geräte und Komponenten meist in Schaltschränken zusammengefasst. Die Geräte und Komponenten sind mittels Leitungen elektrisch bzw. kommunikativ verbunden.

Eine derartige Verdrahtung kann jedoch nur per Hand hergestellt werden.

Dies ist sehr kostenintensiv.

Der Erfindung liegt die Aufgabe zugrunde, dies zu verbessern.

Die Lösung der Aufgabe gelingt durch Anspruch 1, d.h. ein Verfahren zur Herstellung einer elektrischen und/oder kommunikativen Verbindung zwischen wenigstens zwei in einem Schaltschrank angeordneten Komponenten zur Übertragung elektrischer Energie bzw. zum Transport von Daten, wobei die elektrische und/oder kommunikative Verbindung durch Aufbringen eines Materials auf eine Rückwand des Schaltschranks geschaffen wird.

Das Material ist beim Aufbringen vorteilhaft flüssig oder zähflüssig oder dickflüssig, jedoch nicht fest.

Vorteilhaft wurde das Material erwärmt, um eine gewünschte Viskosität zu erreichen. Das Material ist vorteilhaft derart viskos, dass es beim Aufbringen nicht ungehindert wegfließt, sondern Bahnen gebildet werden können.

Die Verbindung ist somit flexibel und günstig herzustellen.

Die Verbindung und die Rückwand sind vorzugsweise stoffschlüssig verbunden.

Vorteilhaft ist eine Ausführung, wonach das Material mittels Schmelzschichtung, vorzugsweise Fused Deposition Modeling oder Fused Filament Fabrication, aufgebracht wird.

Die 3D-Druck-Verfahren Fused Deposition Modeling (FDM) oder Fused Filament Fabrication (FFF) sind Fertigungsverfahren, bei welchen ein Werkstück, z.B. schichtweise, aus einem schmelzfähigen Kunststoff oder auch aus geschmolzenem Metall aufgebaut wird.

Im Sinne der Erfindung werden mittels des Verfahrens elektrisch und/oder kommunikative Verbindungen auf der Rückwand des Schaltschranks geschaffen.

Die Verfahren sind additive Fertigungsverfahren, die sich durch ihre Kostengünstigkeit anbieten.

Vorteilhaft ist eine Ausführung, wonach das Material derart aufgetragen wird, dass Bahnen gebildet werden.

Man kann im Rahmen dieser Erfindung von gedruckten Leiterbahnen sprechen.

Dies ermöglicht einen optimalen Transport von Energie und/oder Daten.

Vorteilhaft ist eine Ausführung, wonach das Material wenigstens einen elektrisch leitfähigen Materialanteil aufweist ist.

Vorzugsweise beträgt der elektrisch leitfähige Materialanteil wenigstens 90%.

Vorteilhaft ist eine Ausführung, wonach das Material Metall aufweist.

Das Material ist vorzugsweise in Form eines Drahtes verfügbar und wird während des Aufbringens erwärmt bzw. erhitzt, derart, dass es flüssig ist und das Aufbringen auf die Rückwand gut gelingt.

Auch eine zähflüssige oder dickflüssige Form ist denkbar.

Vorteilhaft ist eine Ausführung, wonach das Material Lötzinn und/oder Aluminium und/oder Kupfer aufweist.

Diese Materialien eignen sich gut zur Übertragung von elektrischer Energie und Daten.

Vorteilhaft ist eine Ausführung, wonach das Material Glas aufweist.

Hierbei wird das Material derart erhitzt, dass eine Glasfaser direkt auf der Rückwand aufgebracht wird. Dies ist hinsichtlich der Datenübertragung ein großer Vorteil.

Vorteilhaft ist eine Ausführung, wonach das Material in einer Schicht aufgebracht wird.

Dies ist besonders zeitsparend.

Alternativ kann das Material auch in mehreren Schichten aufgebracht werden.

Das Material wird vorteilhaft mittels einer Schicht aufgetragen bzw. in einem Zug aufgetragen, sodass ein gewünschter Querschnitt erreicht wird. Jedoch ist auch das Aufbringen mehrerer Schichten möglich.

Vorteilhaft ist eine Ausführung, wonach an wenigstens einem Ende der elektrischen und/oder kommunikativen Verbindung ein Kontaktierungselement zur Kontaktierung einer Komponente ausgebildet wird.

Kontaktierungselemente können auch mitgedruckt werden. Alternativ können vorgefertigte Elemente eingesetzt werden. Vorteilhaft wird das Material aufgeschmolzen und als flüssige Schmelze auf die Rückwand aufgetragen.

Durch das direkte Auftragen auf die Rückwand kann eine gute Entwärmung erreicht werden. Ein Berührungsschutz kann anschließend aufgebracht werden.

Vorteilhaft ist zudem eine Ausführung, wonach das Material ein elektrisch leitfähiges Material ist.

Dies bietet den Vorteil, dass kein Sintern nötig ist. Das Material kann somit die Aufgabe einer Leiterbahn übernehmen.

Die Lösung der Aufgabe gelingt zudem durch eine Rückwand eines Schaltschranks, aufweisend wenigstens eine elektrische und/oder kommunikative Verbindung zum Verbinden wenigstens zweier Komponenten, hergestellt durch das beschriebene Verfahren.

Ferner gelingt die Lösung der Aufgabe durch einen Schaltschrank, aufweisend wenigstens zwei Komponenten und eine Rückwand.

Im Folgenden wird die Erfindung anhand der in den Figuren dargestellten Ausführungsbeispiele näher beschrieben und erläutert. Es zeigen:
- FIG 1: einen 3D-Drucker während des Aufbringens eines Materials,
- FIG 2: einen Schaltschrank,
- FIG 3: Verfahrensschritte.

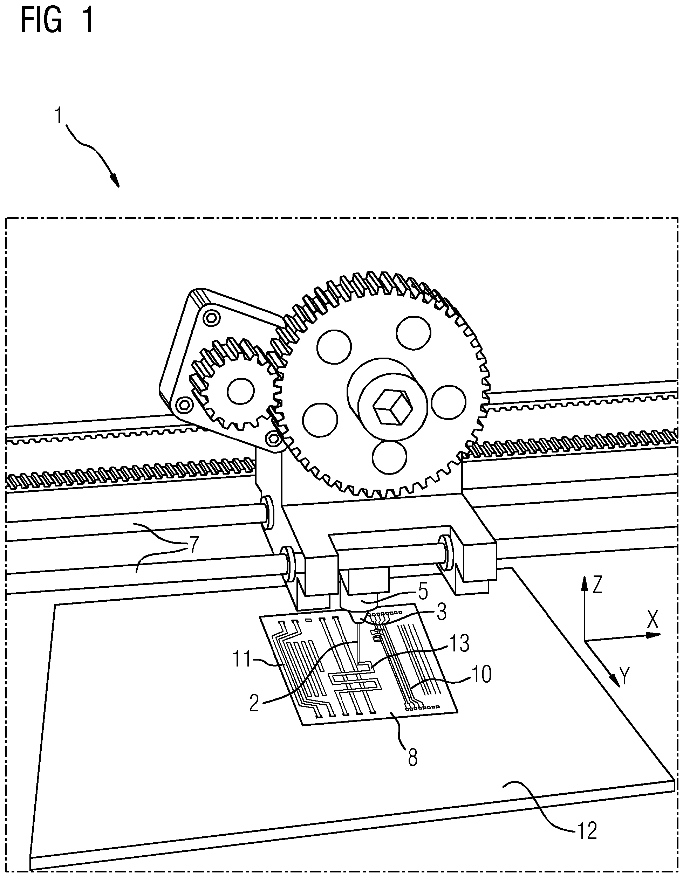

FIG 1 zeigt einen 3D-Drucker 1 während des Aufbringens eines Materials 2.

Das Material ist vorzugsweise gut elektrisch leitfähig und ist beispielsweise Lötzinn und/oder Aluminium und/oder Kupfer.

Das Material 2 wird mittels eines Heizelements 5 erwärmt und durch eine Düse 3 auf eine Rückwand 10 aufgetragen. Die Rückwand 10 liegt in der Figur auf einem Arbeitstisch 12.

Die Düse 3 weist vorteilhaft eine formgebende Öffnung auf. Vorteilhaft wird das Material aus der Düse extrudiert. So können Bahnen 11, 13 gebildet werden.

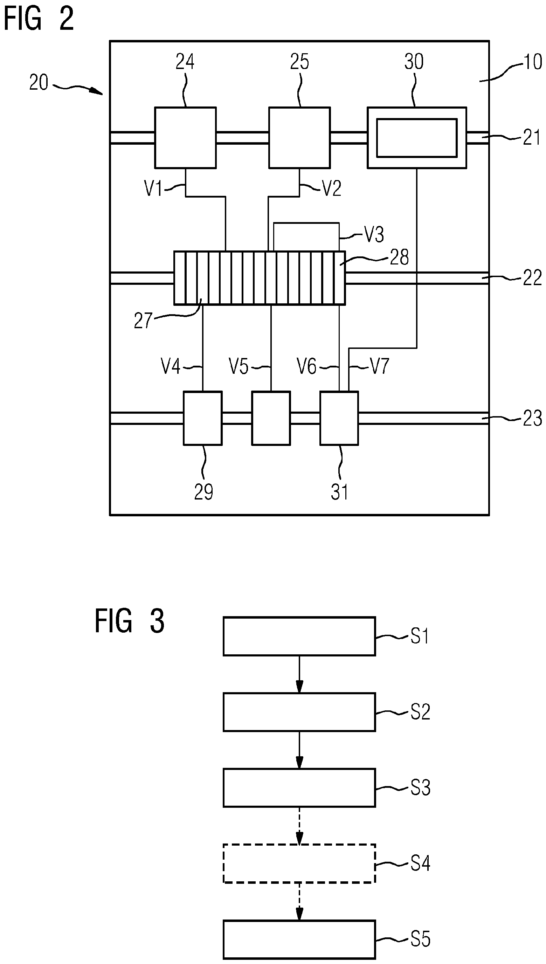

Die Bahnen 11, 13 sind die in FIG 2 gezeigten Verbindungen V1...V7 bzw. Teil davon. Die Verbindungen V1...V7 können z. B. noch mit einem Berührungsschutz oder einer isolierenden Schicht versehen sein. Auch dies kann, muss jedoch nicht, vorteilhaft in einer separaten Schicht, mittels der Düse 3 aufgebracht werden.

Es können mehrere Schichten des Materials aufgetragen werden, um eine gewünschte Dicke der Verbindung zu erreichen.

Die Figur zeigt drei Achsen X, Y und Z. Ein Verfahrweg 7 ist beispielhaft gezeigt.

FIG 2 zeigt einen Schaltschrank 20. Der Schaltschrank 20 weist die Rückwand 10 auf.

Der Schaltschrank 20 beinhaltet die Racks 21, 22 und 23, an welchen mehrere Komponenten 24, 25, 27, 28, 29, 30 angeordnet sind.

In der Figur sind mehrere Verbindungen V1...7 gezeigt, die mittels des beschriebenen Verfahrens (s. FIG 3) hergestellt wurden. Die Verbindungen verbinden Komponenten elektrisch und/oder kommunikativ. Es werden also elektrische Energie und/oder Daten transportiert. Die Verbindungen können als Leiterbahnen bezeichnet werden.

Beispiel: Die Komponente 25 ist ein Netzteil, welches mit der Komponente 28, die eine Sicherung ist, elektrische verbunden ist. Die Komponente 28 und die Komponente 31 sind elektrisch verbunden, wobei die Komponente 31 eine Steuereinheit ist. Die Komponente 30 ist in diesem Beispiel ein Touchscreen. Die Komponente 30 und die Komponente 31 sind elektrisch und kommunikativ verbunden, vergleichbar zu einem Bus, welcher den Austausch von Daten und Energie ermöglicht.

An den jeweiligen Enden der elektrischen und/oder kommunikativen Verbindung ist vorteilhaft ein geeignetes Kontaktierungselement 8 (siehe FIG 1) ausgebildet zur Kontaktierung der jeweiligen Komponente.

Eine Kontaktierung gelingt beispielsweise mittels eines Federkontakts. Vorteilhaft ist der Federkontakt an der Komponente angeordnet. Federkontakt und Komponente sind dann vorteilhaft einteilig.

Alternativ kann der Federkontakt ein einzelnes Bauteil sein, das beispielsweise an die Komponente steckbar ausgeführt ist.

FIG 3 zeigt Verfahrensschritte.

In einem Verfahrensschritt S1 erfolgt eine Bereitstellung der Rückwand.

In einem Verfahrensschritt S2 wird das Material erwärmt.

Das Material S3 wird in einem Verfahrensschritt S3 auf die Rückwand aufgebracht. Das Material wird vorteilhaft mittels Schmelzschichtung, vorzugsweise Fused Deposition Modeling oder Fused Filament Fabrication, aufgebracht.

In einem optionalen Verfahrensschritt S4 wird eine weitere Schicht des Materials oder mehrere weitere Schichten des Materials aufgetragen.

In einem Verfahrensschritt S5 erfolgt eine Fertigstellung, die beispielsweise ein Abkühlen der geschaffenen Verbindungen beinhaltet.

Durch das Abkühlen wird das Material vorteilhaft fest bzw. hart.

## Patentansprüche

1. Verfahren zur Herstellung einer elektrischen und/oder kommunikativen Verbindung (V1, V2, V3, V4, V5, V6, V7) zwischen wenigstens zwei in einem Schaltschrank (20) angeordneten Komponenten (24, 25, 27, 28, 29, 30, 31) zur Übertragung elektrischer Energie bzw. zum Transport von Daten, wobei die elektrische und/oder kommunikative Verbindung (24, 25, 27, 28, 29, 30, 31) durch Aufbringen eines Materials (2) auf eine Rückwand (10) des Schaltschranks (20) geschaffen wird.

2. Verfahren nach Anspruch 1, wobei das Material (2) mittels Schmelzschichtung, vorzugsweise Fused Deposition Modeling oder Fused Filament Fabrication, aufgebracht wird.

3. Verfahren nach einem der vorhergehenden Ansprüche, wobei das Material (2) derart aufgetragen wird, dass Bahnen (11, 13) gebildet werden.

4. Verfahren nach einem der vorhergehenden Ansprüche, wobei das Material (2) wenigstens einen elektrisch leitfähigen Materialanteil aufweist.

5. Verfahren nach einem der vorhergehenden Ansprüche, wobei das Material (2) Metall aufweist.

6. Verfahren nach einem der vorhergehenden Ansprüche, wobei das Material (2) Lötzinn und/oder Aluminium und/oder Kupfer aufweist.

7. Verfahren nach einem der vorhergehenden Ansprüche, wobei das Material (2) Glas aufweist.

8. Verfahren nach einem der vorhergehenden Ansprüche, wobei das Material (2) in einer Schicht aufgebracht wird.

9. Verfahren nach einem der vorhergehenden Ansprüche, wobei an wenigstens einem Ende der elektrischen und/oder kommunikativen Verbindung ein Kontaktierungselement (8) zur Kontaktierung einer Komponente (24, 25, 27, 28, 29, 30, 31) ausgebildet wird.

10. Verfahren nach einem der vorhergehenden Ansprüche, wobei das Material (2) aufgeschmolzen wird und als flüssige Schmelze auf die Rückwand (10) aufgetragen wird.

11. Verfahren nach einem der vorhergehenden Ansprüche, wobei das Material (2) ein elektrisch leitfähiges Material ist.

12. Rückwand (10) eines Schaltschranks (20), aufweisend wenigstens eine elektrische und/oder kommunikative Verbindung (V1, V2, V3, V4, V5, V6, V7) zum Verbinden wenigstens zweier Komponenten (24, 25, 27, 28, 29, 30, 31), hergestellt durch ein Verfahren nach einem der Ansprüche 1 bis 11.

13. Schaltschrank (20), aufweisend wenigstens zwei Komponenten (24, 25, 27, 28, 29, 30, 31) und eine Rückwand (10) nach Anspruch 12.
